(19) Europäisches Patentamt
European Patent Office
Office européen des brevets

(11) **EP 2 269 045 B1**

(12) # EUROPÄISCHE PATENTSCHRIFT

(45) Veröffentlichungstag und Bekanntmachung des Hinweises auf die Patenterteilung:
**16.05.2012 Patentblatt 2012/20**

(21) Anmeldenummer: **09726996.3**

(22) Anmeldetag: **03.04.2009**

(51) Int Cl.:
**G01N 24/12** (2006.01)    **G01R 33/62** (2006.01)
**G01R 33/345** (2006.01)

(86) Internationale Anmeldenummer:
**PCT/EP2009/002488**

(87) Internationale Veröffentlichungsnummer:
**WO 2009/121630 (08.10.2009 Gazette 2009/41)**

(54) **DOPPELRESONANZSTRUKTUR UND VERFAHREN ZUR UNTERSUCHUNG VON PROBEN MITTELS DNP- UND/ODER ENDOR**

DOUBLE-RESONANT STRUCTURE AND METHOD FOR EXAMINING SAMPLES USING DNP AND/OR ENDOR

STRUCTURE DE DOUBLE RÉSONANCE ET PROCÉDÉ POUR L'ÉTUDE D'ÉCHANTILLONS À L'AIDE D'UNE DNP ET/OU D'UNE ENDOR

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **03.04.2008 DE 102008017135**

(43) Veröffentlichungstag der Anmeldung:
**05.01.2011 Patentblatt 2011/01**

(73) Patentinhaber: **Johann Wolfgang Goethe-Universität Frankfurt am Main**
**60325 Frankfurt am Main (DE)**

(72) Erfinder:
• **PRISNER, Thomas**
**61118 Bad Vilbel (DE)**
• **DENYSENKOV, Vasyl**
**60439 Frankfurt am Main (DE)**

(74) Vertreter: **Lucke, Andreas**
**Boehmert & Boehmert**
**Pettenkoferstrasse 20-22**
**80336 München (DE)**

(56) Entgegenhaltungen:
**JP-A- 2005 121 409**

• WEIS V ET AL: "High-Field DNP and ENDOR with a Novel Multiple-Frequency Resonance Structure" JOURNAL OF MAGNETIC RESONANCE, ACADEMIC PRESS, ORLANDO, FL, US, Bd. 140, Nr. 1, 1. September 1999 (1999-09-01), Seiten 293-299, XP004407163 ISSN: 1090-7807 in der Anmeldung erwähnt
• BURGHAUS O ET AL: "A novel high-field/high-frequency EPR and ENDOR spectrometer operating at 3 mm wavelength" MEASUREMENT SCIENCE AND TECHNOLOGY, IOP, BRISTOL, GB, Bd. 3, Nr. 8, 1. August 1992 (1992-08-01), Seiten 765-774, XP020065284 ISSN: 0957-0233
• SINGEL D J ET AL: "A SPECTROMETER FOR EPR, DNP, AND MULTINUCLEAR HIGH-RESOLUTION NMR" JOURNAL OF MAGNETIC RESONANCE, ACADEMIC PRESS, ORLANDO, FL, US, Bd. 81, Nr. 1, 1. Januar 1989 (1989-01-01), Seiten 145-161, XP000006752 ISSN: 1090-7807
• SLOOP D J ET AL: "SPIN-ECHO-ENDOR STUDIES OF THE PHOTOEXCITED TRIPLET STATE OF PENTACENE IN P-TERPHENYL CRYSTALS AT ROOM TEMPERATURE" JOURNAL OF MAGNETIC RESONANCE, ACADEMIC PRESS, ORLANDO, FL, US, Bd. 86, Nr. 1, 1. Januar 1990 (1990-01-01), Seiten 156-159, XP000102281 ISSN: 1090-7807
• JOHANSSON B.: "A stripline resonator for ESR" REVIEW OF SCIENTIFIC INSTRUMENTS USA, Bd. 45, Nr. 11, November 1974 (1974-11), Seiten 1445-1447, XP002535682 GB ISSN: 0034-6748

**EP 2 269 045 B1**

## Beschreibung

Die vorliegende Erfindung betrifft eine Doppelresonanzstruktur für DNP- und/oder ENDOR-Experimente nach dem Oberbegriff des Anspruchs 1. Ferner betrifft sie ein Verfahren zur Untersuchung von Proben mittels DNP- und/oder ENDOR nach dem Oberbegriff des Anspruchs 19.

Die Kernspinresonanzspektroskopie (NMR-Spektroskopie, NMR = Nuclear magnetic resonance) ist eines der wichtigsten spektroskopischen Verfahren zur Aufklärung der Struktur und Dynamik von Molekülen, insbesondere in der organischen Chemie und in der Biochemie. Bei manchen Anwendungen, beispielsweise der Untersuchung von großen Biomolekülen in vitro und in vivo, stößt jedoch die Empfindlichkeit von NMR-Spektrometern an ihre Grenzen. Die mangelnde Empfindlichkeit kann zu einem gewissen Grade dadurch verbessert werden, dass ein höheres externes magnetisches Feld angelegt wird, aber dies ist nur in begrenztem Umfang und zu sehr hohen Kosten möglich.

Eine sehr vielversprechende Alternative, die Empfindlichkeit von NMR-Messungen beispielsweise bei Biomolekülen zu erhöhen, besteht in einem Verfahren, das als "dynamische Kernpolarisierung" bzw. "DNP-Verfahren", entsprechend der Abkürzung des englischen Begriffs "dynamic nuclear polarisation", bekannt ist. Die DNP resultiert aus der Übertragung von der Spinpolarisierung der Elektronen auf die Kerne nach einem Prinzip, das auch als "Overhauser-Effekt" bekannt ist. Um sich die DNP in der NMR-Spektroskopie nutzbar zu machen, müssen zuerst die Elektronenspinpolarisationen auf das Kernspinsystem übertragen werden. Dazu wird die Probe mit einer Elektronenspinresonanzfrequenz, üblicherweise als EPR-Frequenz bezeichnet, angeregt, wobei "EPR" die Abkürzung für den englischen Begriff "electronic paramagnetic resonance" ist. Die EPR-Frequenz, auch Larmor-Frequenz genannt, entspricht der Aufspaltung der Energie von Elektronenspin-Energiequantenzuständen eines Atoms oder Moleküls in einem äußeren Magnetfeld nach dem Zeemann-Effekt, die ohne äußeres Magnetfeld entartet wären. Die Aufspaltung der Energiezustände ist proportional zur Stärke B des externen Magnetfeldes und somit ist der Wert der EPR-Frequenz von der Magnetfeldstärke abhängig. In praktisch relevanten Anwendungen liegt sie jedoch stets im Mikrowellenbereich. Die Veränderung der Polarisierung der Elektronenspins durch Einstrahlen von EPR-Mikrowellen wird oft anschaulich auch als "Pumpen" bezeichnet.

Die Verstärkung der NMR-Signale aufgrund der DNP ist, solange die EPR-Übergänge nicht gesättigt sind, proportional zum Quadrat der Intensität des EPR-Mikrowellenfeldes. Um ein EPR-Mikrowellenfeld mit möglichst hoher Leistung bzw. Feldstärke zu erhalten, werden daher vorzugsweise Mikrowellenresonatoren verwendet, in denen die Probe zur Stimulierung der EPR-Übergänge angeordnet wird.

Ähnlich wie die EPR basiert auch die Kernspinresonanz (NMR) auf Übergängen zwischen Quantenzuständen eines Spins in einem externen Magnetfeld, mit dem Unterschied, dass die Energieaufspaltung der Kernspins wesentlich kleiner ist als bei der EPR. Die NMR-Frequenzen liegen typischerweise im zweistelligen Megahertzbereich, also noch im Hochfrequenz-Bereich (HF-Bereich). Anstelle des Begriffes "Hochfrequenz" wird in der Literatur auch der Begriff "Radiofrequenz" verwendet. Denn der Begriff "Hochfrequenz" soll nicht darüber hinwegtäuschen, dass diese NMR-Frequenzen eigentlich die niedrigeren Frequenzen des Systems sind, nämlich niedriger sind als die oben genannten Mikrowellenfrequenzen. Da auch für die NMR-Spektroskopie eine hohe Intensität des HF-Feldes notwendig ist, wird vorzugsweise auch eine HF-Resonanzspule verwendet. Daher bieten sich für DNP-NMR-Experimente sogenannte Doppelresonanzstrukturen an, die einen Mikrowellen-Resonator für EPR-Übergänge und eine HF-Spule für NMR-Übergänge aufweisen, sodass dieselbe Probe gleichzeitig in einem MW-Feld und einem HF-Feld mit hohen Intensitäten angeordnet werden kann.

Ein der DNP-NMR-Spektroskopie konzeptionell verwandtes Verfahren ist die sogenannte Elektronen-Kern-Doppelresonanz-Spektroskopie, die nach dem englischen Begriff "electron nuclear double-resonance", als ENDOR-Spektroskopie bezeichnet wird. Die ENDOR-Spektroskopie ist eine besondere Art der EPR-Spektroskopie, bei der NMR-Übergänge in der Probe durch Einstrahlen von HF-Feldern erzeugt werden. Insofern ist die ENDOR-Spektroskopie der DNP-NMR-Spektroskopie konzeptionell sehr ähnlich, nur dass bei dieser mit HF-Feldern "gepumpt" wird und EPR-Spektroskopie betrieben wird. Auch für ENDOR-Experimente wird eine Doppelresonanzstruktur gebraucht.

Eine Doppelresonanzstruktur nach dem Oberbegriff des Anspruchs 1 ist aus dem Artikel von Weis et al. (High field DNP and ENDOR with novel multiple-frequency resonance structure, J. Magn. Reson. 140, 293-299 (1999)) bekannt. Diese vorbekannte Doppelresonanzstruktur umfasst einen zylindrischen Mikrowellenresonator, der aus einem schraubenförmig gewundenen leitenden Band gebildet ist. Das schraubenförmig gewundene leitende Band bildet dabei eine Spule, die die Funktion des HF-Resonators einnimmt. Der zylindrische MW-Resonator wird daher auch als Helix-Resonator bezeichnet. In der Mantelfläche der Helix ist eine Iris ausgebildet, durch die Mikrowellen in den Helix-Resonator eingespeist werden können. Die Länge des Resonators kann durch verstellbare Kolben eingestellt werden, die an beiden Enden der Helix in diese eingeführt sind.

In dem bekannten Helix-Resonator kann eine zylindrische $TE_{011}$ Mikrowellenmode angeregt werden, so dass eine recht hohe Mikrowellen-Energiedichte im MW-Resonator erreicht werden kann. Allerdings sind die Abmessungen des Helix-Resonators mit der Wellenlänge korreliert, und wenn die Wellenlänge der Mikrowellen entsprechend der EPR-Bedingung in starken externen Magnetfeldern unter einen Millimeter sinkt, begrenzt die geringe Größe des Helix-Resonators das Probenvolumen, das in dem Helix-Resonator untergebracht werden kann.

Im Falle von flüssigen, insbesondere wässrigen Proben besteht bei der Verwendung des bekannten Helix-Resonators ferner das Problem, dass dessen Volumen bei weitem nicht mit dem Probenvolumen ausgenutzt werden kann, weil sich die Probe unter Einstrahlung der Mikrowellen zu stark erwärmen würde. Grund für die starke Erwärmung ist die frequenzabhängige dielektrische Perimitivität des Wassers bei Einstrahlung von Mikrowellen. Beispielsweise hat die komplexe dielektrische Permitivität von Wasser bei einer Mikrowellenfrequenz von 260 GHz einen Realteil ß' = 5,6 und einen Imaginärteil ε" = 5,8, wobei die dielektrischen Verluste proportional zum Imaginärteil ε" der Permitivität sind. Die verhältnismäßig starken Verluste, auch "Einfügungsverluste" genant, führen einerseits dazu, dass das MW-Feld in der Probe deutlich geringer ist als außerhalb, und andererseits dazu, dass sich die Probe stark erwärmt.

Wenn beispielsweise Biomoleküle in wässriger Lösung untersucht werden sollen, verbietet sich eine starke Erwärmung der Probe jedoch, da die Biomoleküle durch die Erwärmung zerstört werden könnten. Die Erfinder haben versuchsweise eine wässrige Probe in einer Kapillare mit einem Durchmesser von nur 0,1 mm verwendet und mussten feststellen, dass sich die Probe unter Einstrahlung von Mikrowellen um 90°C erhöhte. Selbst bei einem Durchmesser von lediglich 0,05 mm der Kapillare ergab sich noch eine Erwärmung von 17°C. Dies bedeutet, dass das Probevolumen stets verhältnismäßig klein gehalten werden muss, so dass der Füllfak-

$$\text{tor } \eta = \frac{V_s \left\langle B_{HF}^2 \right\rangle_s}{V_{struk} \left\langle B_{HF}^2 \right\rangle_{struk}} \text{ verhältnismäßig klein ist,}$$

was zu einer verringerten NMR-Empfindlichkeit führt.

Hierbei ist $V_s$ das Volumen der Probe, $\left\langle B_{HF}^2 \right\rangle_s$ der Durchschnittswert der HF-Magnetfeldstärke $B_{HF}$ im Bereich der Probe, $V_{struk}$ das Volumen der Struktur und $\left\langle B_{HF}^2 \right\rangle$ der Durchschnittswert der Magnetfeldstärke $B_{HF}$ des Feldes im Bereich der Struktur. Wenn die MW-Leistung verringert wird, um eine übermäßige Erwärmung der Probe zu verhindern, führt dies zu einer Schwächung der DNP und somit wiederum zu einer Verschlechterung der NMR-Empfindlichkeit.

Eine weitere Doppelresonanzstruktur, ein sogenannter Hohlraum-Resonator für ENDOR ist in der JP2005-121409 beschrieben. Der Resonator verwendet eine HF-Spule, die um die Probe gewickelt ist, die ihrerseits in einem MW-Hohlraum angeordnet ist. Diese Struktur ist für ENDOR-Spektroskopie geeignet, nicht jedoch für DNP-Anwendungen, weil die HF-Spule zu einer Störung der Verteilung des elektrischen MW-Feldes über dem Probenvolumen führt, was zu einer unvorteilhaften Erwärmung der Probe führt.

Der Erfindung liegt die Aufgabe zugrunde, eine Doppelresonanzstruktur und ein Verfahren zur Untersuchung von Proben mittels DNP-NMR- und/oder ENDOR anzugeben, die eine erhöhte Messempfindlichkeit gestatten.

Diese Aufgabe wird durch eine Doppelresonanzstruktur nach Anspruch 1 und ein Verfahren nach Anspruch 12 gelöst. Das Verfahren nach Anspruch 12 ist grundsätzlich aus dem Stand der Technik bekannt, zeichnet sich jedoch durch die Verwendung der erfindungsgemäßen Doppelresonanzstruktur aus. Vorteilhafte Weiterbildungen sind in den abhängigen Ansprüchen angegeben.

Die Doppelresonanzstruktur der Erfindung unterscheidet sich von derjenigen aus dem Stand der Technik dadurch, dass der HF-Resonator durch einen Streifen-Resonator gebildet wird, wobei ein Abschnitt des Streifen-Resonators gleichzeitig einen Teil des MW-Resonators bildet, der als spiegel für mikrowellen dienen kann.

Der "Streifen-Resonator" kann dabei ein durch irgendeinen streifenförmigen Leiter gebildet sein, der als Resonator für das HF-Feld geeignet ist und gleichzeitig als Teil des MW-Resonators verwendet werden kann. Ein Beispiel für einen derartigen "Streifen-Resonator" kann ein "Stripline-Resonator" oder ein "Microstrip-Resonator" sein. Mit einem derartigen Streifen-Resonator lassen sich HF-Felder für NMR-Übergänge mit ausreichender Stärke erzeugen. Gleichzeitig bildet der Streifen-Resonator einen Abschnitt des MW-Resonators. Bei den hier relevanten MW-Frequenzen handelt es sich um sogenannte "quasi-optische" Mikrowellen, und der besagte Abschnitt des Streifen-Resonators kann einen Spiegel für einen MW-Resonator bilden. Bei den hier relevanten MW-Figuren dient der besagte Abschnitt des Streifen- bzw. Stripline-Resonators als ein Spiegel des MW-Resonators, an dem die Mikrowellen quasi optisch reflektiert werden. Dadurch wird eine, verglichen mit dem Helix-Resonator, offenere Struktur geschaffen, die im Hinblick auf Wärmedissipation vorteilhaft ist und es gestattet, größere Probenvolumina zu verwenden, als dies mit dem bekannten Helix-Resonator möglich ist.

In einer vorteilhaften Weiterbildung umfasst der MW-Resonator einen sphärischen Spiegel und einen ebenen Spiegel für Mikrowellen, die einander gegenüber stehen, wobei der ebene Spiegel durch einen Abschnitt des Streifen-Kondensators gebildet wird. Ein derartiger MW-Resonator wird auch als "semikonfokaler Fabry-Perot-Resonator" bezeichnet. In dieser Anordnung hat der Streifen-Resonator somit eine dreifache Funktion:

Erstens erzeugt er ein HF-Feld, dessen Magnetfeldstärke $B_{HF}$ größer ist als beim bekannten Helix-Resonator. Dies verspricht eine erhöhte NMR-Empfindlichkeit.

Zweitens dient der Streifen-Resonator als Spiegel in dem MW-Resonator, so dass die unterschiedlichen Resonatoren auf ideale Weise kombiniert werden können, ohne sich in ihrer Funktion gegenseitig zu beeinträchtigen. Die dadurch erhaltene Struktur bietet ausreichend Platz für Probenvolumina, die um einen Faktor von 10 größer sein können, als bei dem bekannten Helix-Resonator.

Und drittens wirkt der Streifen-Resonator als Wärmesenke, durch die Wärme, die insbesondere beim Bestrahlen einer wässrigen Probe mit Mikrowellen erzeugt wird, abgeführt wird, so dass selbst verhältnismäßig große Probenvolumina verwendet werden können, ohne dass sie sich übermäßig erwärmen.

Vorzugsweise ist in dem sphärischen Spiegel eine Iris ausgebildet, durch die Mikrowellen in den MW-Resonator einspeisbar sind. Ferner sind der sphärische Spiegel und der ebene Spiegel vorzugsweise so ausgebildet und angeordnet, dass sich ein Mikrowellen-Magnetfeld in der $TEM_{00n}$-Mode des MW-Resonators ausbilden lässt. Die Verwendung der $TEM_{00n}$-Mode gestattet es, hohe Magnetfeldstärken in einem vergleichsweise großen Volumenbereich zu erzeugen, so dass wiederum vergleichsweise große Probenvolumina untersucht werden können.

Vorzugsweise hat der Streifen-Resonator ein erstes Ende, welches mit Massepotential verbunden ist, und ist der Abschnitt des Streifen-Resonators, der einen Teil des MW-Resonators bildet, im Bereich des ersten Endes des Streifen-Resonators angeordnet. Am geerdeten Ende des Streifen-Resonators hat die Spannung ein Minimum und daher der Strom ein Maximum, so dass das von dem Streifen-Resonator erzeugte Magnetfeld $B_{HF}$ im Bereich des geerdeten Endes maximal ist. Diese Anordnung hat also zur Folge, dass HF-Magnetfelder $B_{HF}$ in dem Bereich des MW-Resonators, in dem sich die Probe befindet, maximal sind, was zu einer erhöhten NMR-Empfindlichkeit führt.

Vorzugsweise hat der Streifen-Resonator ein zweites Ende, an dem ein Kondensator zum Einstellen der Resonanzfrequenz des Streifen-Resonators vorgesehen ist.

In einer besonders vorteilhaften Ausführungsform der Doppelresonanzstruktur ist eine Stelle zur Aufnahme einer Probe vorgesehen, die mit dem Streifen-Resonator wärmeleitend verbunden ist. Beispielsweise kann die Stelle zur Aufnahme der Probe so ausgebildet sein, dass die aufgenommene Probe mit dem Streifen-Resonator in direktem Kontakt ist. Damit kann Wärme, die durch Mikrowellenabsorption in der Probe erzeugt wird, auf effiziente Weise von dem Streifen-Resonator abgeführt werden. Dieser Aufbau ist ideal für die spektroskopische Untersuchung von wässrigen Proben geeignet, die nur wenig erwärmt werden dürfen, insbesondere für die Untersuchung von Biomolekülen in wässriger Lösung.

Vorzugsweise ist ein Anschluss für eine HF-Leitung, beispielsweise für ein Koaxialkabel, vorgesehen, über den die HF-Signale an den Streifen-Resonator anlegbar sind. Der Begriff "Signale" ist weit zu verstehen und umfasst jede Art von elektromagnetischen Wellen, Pulsen, Anregungspulsen etc.. Dabei ist vorzugsweise ein einstellbarer Matching-Kondensator zwischen dem Streifen-Resonator und dem Anschluss für HF-Signale vorgesehen, über den die Einkopplung der Signale in den Streifen-Resonator optimierbar ist.

In einer vorteilhaften Ausführungsform ist die Doppelresonanzstruktur als Sonde bzw. Probenkopf ausgebildet, die in eine Bohrung eines Magneten einführbar ist. Dieser Magnet, in den der Probenkopf einführbar ist, ist zum Erzeugen eines statischen Magnetfeldes bestimmt, in dem die an sich entarteten Quantenzustände der Probe durch Wechselwirkung des Elektronenspins bzw. des Kernspins mit dem externen statischen Magnetfeld aufgespalten werden. Dabei hat der Probenkopf vorzugsweise ein Gehäuse, welches mit Massepotential verbunden ist. Der Streifen-Resonator bildet dann zusammen mit diesem geerdeten Gehäuse eine sogenannte "Stripline"-Struktur.

In einer bevorzugten Ausführungsform wird der Streifen-Resonator durch einen länglichen Abschnitt einer Leiterfläche gebildet, der entlang eines Teils seiner Länge durch nichtleitende Aussparungen von dem Rest der Leiterfläche getrennt ist. Wie unten anhand eines Ausführungsbeispiels näher erläutert wird, kann durch diesen Aufbau eine Konzentration des HF-Magnetfelds in der Nähe der Probe erreicht werden, weil die Magnetfeldlinien durch die nichtleitenden Aussparungen hindurch laufen und das Magnetfeld somit im Bereich des Streifen-Resonator-Abschnittes der Fläche konzentriert ist. Bei der Leiterfläche kann es sich beispielsweise um eine Metallisierungsschicht handeln, die auf einem dielektrischen Substrat gebildet ist. Dabei können die nichtleitenden Aussparungen durch Bereiche gebildet sein, an denen die Metallisierung ausgespart ist. Ein ähnlicher Effekt könnte jedoch auch durch eine geschlitzte leitende Platte erreicht werden

Die hier beschriebene Doppelresonanzstruktur kann zu einem DNP-NMR-Spektrometer weitergebildet werden. Dazu sind eine Mikrowellenquelle, die zur Einspeisung von Mikrowellen in den MW-Resonator mit der Doppelresonanzstruktur verbunden ist, und eine NMR-Einrichtung vorgesehen, die mit der Doppelresonanzstruktur zur Einspeisung von HF-Signalen in den Streifen-Resonator und zum Empfang von HF-Signalen von dem Streifen-Resonator verbunden ist.

Ebenso kann die erfindungsgemäße Doppelresonanzstruktur zu einem ENDOR-Spektrometer weitergebildet werden, bei dem eine Mikrowellenquelle, die zur Einspeisung von Mikrowellen in den MW-Resonator und zum Empfang von MW-Signalen aus dem MW-Resonator mit der Doppelresonanzstruktur verbunden ist, und eine HF-Quelle vorgesehen sind, die zum Einspeisen von HF-Signalen in den Streifen-Resonator mit der Doppelresonanzstruktur verbunden ist. Ferner kann die erfindungsgemäße Doppelresonanzstruktur in einem kombinierten DNP-NMR/ENDOR-Spektrometer verwendet werden, welches zu beiden Betriebsmodi in der Lage ist.

Weitere Vorteile und Merkmale der Vorrichtungen des Verfahrens der Erfindung ergeben sich aus der folgenden Beschreibung, in der die Erfindung anhand eines Ausführungsbeispiels unter Bezugnahme auf die beigefügten Zeichnungen näher erläutert wird. Darin zeigen:

Figur 1 eine Längsschnittansicht der Resonanzstruktur nach einer Weiterbildung der Erfindung,

Figur 2 eine Querschnittsansicht der Doppelresonanzstruktur von Figur 1, in der Magnetfeldlinien $B_{HF}$ des HF-Feldes eingezeichnet sind,

Figur 3 eine Querschnittsansicht der Doppelresonanzstruktur von Figur 1, in der Magnetfeldlinien $B_{MW}$ des Mikrowellenfeldes eingezeichnet sind,

Figur 4 ein Längsschnitt, in dem eine alternative Ausführungsform einer Doppelresonanzstruktur gezeigt ist,

Figur 5 eine schematische Darstellung der Komponente einer Mikrowellenbrücke,

Figur 6 eine funktionelle Darstellung der Mikrowellenbrücke von Figur 5,

Figur 7 eine Querschnittsansicht einer Doppelresonanzstruktur ähnlich derjenigen von Figur 2 und Figur 3, in der die Magnetfeldlinien $B_{MW}$ des Mikrowellenfeldes und Magnetfeldlinien $B_{HF}$ des HF-Feldes eingezeichnet sind, und

Figur 8 eine schematische perspektivische Ansicht, die eine alternative Ausführungsform einer Doppelresonanzstruktur zeigt.

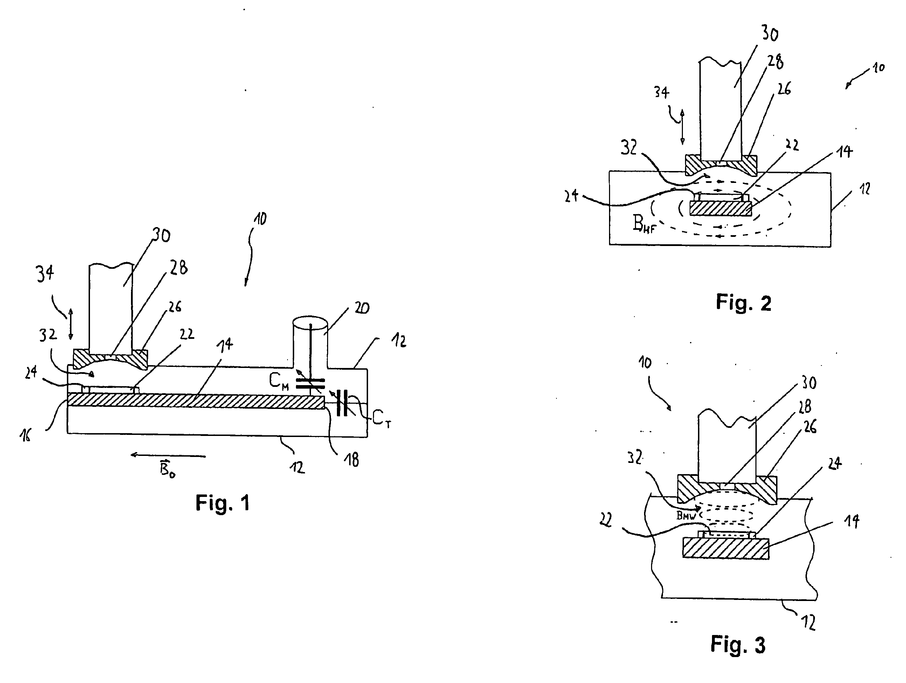

Figur 1 zeigt eine Doppelresonanzstruktur 10 in einer Längsschnittansicht, und Figuren 2 und 3 zeigen dieselbe Doppelresonanzstruktur 10 in jeweils einer Querschnittsansicht. Die Doppelresonanzstruktur 10 umfasst ein Gehäuse 12, welches mit Massepotential verbunden ist. In dem Gehäuse 12 ist ein Streifen-Resonator 14 angeordnet. Der Streifen-Resonator 14 ist ein streifenförmiger Innenleiter, der an seinem in der Figur 1 linken Ende 16 mit dem Gehäuse 12 verbunden ist, so dass das erste Ende 16 ebenfalls auf Massepotential liegt. Ein derartiger Streifen-Resonator 14 ist auch als "Stripline" oder "Microstrip" bekannt. Der Streifen-Resonator 14 hat ein zweites, in der Darstellung von Figur 1 rechtes Ende 18. Zwischen dem zweiten Ende 18 und dem Gehäuse 12 ist ein einstellbarer Kondensator $C_T$ angeordnet. Durch Einstellen der Kapazität des Kondensators $C_T$ lässt sich die Resonanzfrequenz des Streifen-Resonators 14 einstellen.

Im Bereich des zweiten Endes 18 des Streifen-Resonators 14 ist ein Anschluss 20 für eine HF-Leitung (nicht gezeigt), beispielsweise ein Koaxialkabel, vorgesehen. Über diesen Anschluss können HF-Signale von einer HF-Quelle an den Streifen-Resonator 14 angelegt werden und gebenenfalls vom Streifen-Resonator 14 empfangen werden. Um die Kopplung zwischen diesen HF-Signalen und dem Streifen-Resonator 14 optimieren zu können, ist zwischen dem Anschluss 20 und dem zweiten Ende des Streifen-Resonators 14 ein Kondensator $C_M$ geschaltet, dessen Kapazität sich ebenfalls einstellen lässt. Ein derartiger Kondensator wird auch als "Matching-Kondensator" bezeichnet.

In der Nähe des ersten Endes 16 des Streifen-Resonators 14 ist eine Probe 22 angeordnet. Bei der Probe 22 kann es sich beispielsweise um eine wässrige Probe handeln, in der zu untersuchende Biomoleküle enthalten sind. Die Probe 22 befindet sich innerhalb eines kleinen Teflonringes, der auf dem Streifen-Resonator platziert ist. Die Probe 22 ist in den Innenraum des Rings 24 gefüllt und somit unmittelbar auf der Oberfläche des Streifen-Resonators 14 angeordnet. Das Volumen der Probe 20 kann beispielsweise 200 nl betragen.

Oberhalb der Probe 22 ist ein sphärischer Spiegel 26 angeordnet, in dem eine Iris 28 ausgebildet ist. Der sphärische Spiegel 26 ist mit einem Wellenleiter 30 für Mikrowellen verbunden, durch den Mikrowellen in den Zwischenraum zwischen dem Streifen-Resonator 14 und dem sphärischen Spiegel 26 eingespeist werden können. Die Iris 28 kann schlitzförmig sein, um linear polarisierte Mikrowellenmoden zu erzeugen, oder kreisförmig sein, um zirkular polarisierte Mikrowellenmoden zu erzeugen.

Der sphärische Spiegel 26 und der dem sphärischen Spiegel 26 gegenüberliegende Abschnitt des Streifen-Resonators 14 bilden einen Mikrowellen-Resonator 32, der auch als semikonfokaler Fabry-Perot-Resonator bezeichnet wird. Der Abstand zwischen dem sphärischen Spiegel 26 des MW-Resonators 32 und dem Streifen-Resonator 14 ist einstellbar, wie durch den Doppelpfeil 34 schematisch angedeutet ist. Durch Verändern des Abstandes zwischen dem sphärischen Spiegel 26 und dem Streifen-Resonator 14 kann die Resonanzfrequenz des MW-Resonators 32 eingestellt werden.

Im Folgenden wird die Funktion der Doppelresonanzstruktur 10 von Figur 1 beschrieben:

Der Begriff "Doppelresonanz" weist darauf hin, dass im Bereich der Probe 22 Resonanzbedingungen für zwei unterschiedliche elektromagnetische Felder geschaffen werden. Die eine Resonanz betrifft die Resonanz des Streifen-Resonators 14, der mit einer Frequenz betrieben wird, die einer NMR-Resonanz in einem äußeren Magnetfeld $B_0$ entspricht. Bei einem externen Magnetfeld $B_0$ von rund 10 T beträgt die NMR-Frequenz beispielsweise ca. 400 MHz. Die Feldlinie des Hochfrequenzmagnetfeldes $B_{HF}$, welches von dem Resonator 14 erzeugt wird, ist in Figur 2 schematisch dargestellt. Da der Resonator 14 an seinem ersten Ende 16 mit Massepotential verbunden ist, sind an diesem ersten Ende 16 die Ströme und somit das Magnetfeld $B_{HF}$ maximal. In diesem maximalen Magnetfeld $B_{HF}$ ist die Probe 22 angeordnet.

Die zweite Resonanz der Doppelresonanzstruktur bezieht sich auf eine Resonanz im Mikrowellenbereich, nämlich bei Frequenzen, die EPR-Übergängen entsprechen. Bei einem äußeren Magnetfeld $B_0$ von rund 10 T beträgt die EPR-Resonanz-Frequenz ca. 260 GHz. Das entsprechende Mikrowellenfeld wird in dem Resonator 32 ausgebildet und das Magnetfeld $B_{MW}$ dieser Mode ist in Figur 3 schematisch dargestellt. Die im MW-Resonator 32 ausgebildete Mode wird als $TEM_{00n}$ bezeichnet, wobei n eine ganze Zahl ist. Die Mode $TEM_{00n}$ ist axialsymmetrisch, und das Feldprofil in einer Ebene parallel zur Oberfläche des Streifen-Resonators 14 hat eine Gauß'sche Form mit einer Breite, die von dem Abstand vom sphärischen Spiegel 26 abhängt. Die höchste Magnetfeldstärke des MW-Magnetfeldes ist $B_{MW}$ tritt unmittelbar an der Oberfläche des Streifen-Resonators 14 auf, also dort wo die Probe 22 angeordnet ist. Das nächste Maximum der Magnetfeldstärke $B_{MW}$ befindet sich eine halbe Wellenlänge oberhalb der Oberfläche des Streifen-Resonators 14. Daher beträgt die maximale Dicke der Probe 22 vorzugsweise ungefähr 10% der Resonanz-Wellenlänge. Wenn die Probe 22 dicker wäre, würde sie auch im Bereich der stehenden Welle mit hohem elektrischen Feld liegen, wodurch das Probermaterial 22 übermäßig aufgeheizt würde und der Gütefaktor Q des Resonators 32 beeinträchtigt wäre.

Da die Probe 22 unmittelbar auf dem Streifen-Resonator 14 angeordnet ist, kann über diesen Wärme von der Probe abgeführt werden. Dies ist ein besonderer Vorteil gegenüber beispielsweise einem Helix-Resonator, bei dem eine Erwärmung aufgrund von Mikrowellenabsorption nur schwer zu vermeiden ist, allenfalls durch sehr kleine Probenvolumina und geringer Mikrowellenleistung, was jedoch die Messgenauigkeit verringert.

Unter Ausnutzung der Doppelresonanz können DNP-NMR-Experimente oder ENDOR-Experimente durchgeführt werden. Bei DNP-NMR-Experimenten werden Elektronenspins in der Probe 22 durch das Mikrowellenfeld polarisiert, und diese Polarisation wird nach dem Overhauser Effekt auf die Kernspins übertragen, wodurch sich bei Messung von NMR-Spektren ein erhöhtes NMR-Signal ergibt. Bei ENDOR-Experimenten tritt der umgekehrte Fall auf: Die Probe wird mit NMR-Frequenzen angeregt, und es werden EPR-Spektren gemessen. Die Doppelresonanzstruktur 10 ist für beide Arten von Experimenten geeignet und kann somit als Sonden- oder Probenkopf sowohl für ein ENDOR-Spektrometer als auch für ein DNP-NMR-Spektrometer verwendet werden. Auch kann sie bei einer geeigneten Mikrowellenbrücke, die mit dem Mikrowellen-Wellenleiter 30 verbunden ist, und einer geeigneten NMR-Einrichtung, die mit dem HF-Anschluss 20 verbunden ist, in einem kombinierten ENDOR/DNP-NMR-Spektrometer verwendet werden, welches wahlweise in beiden dieser Modi betrieben werden kann.

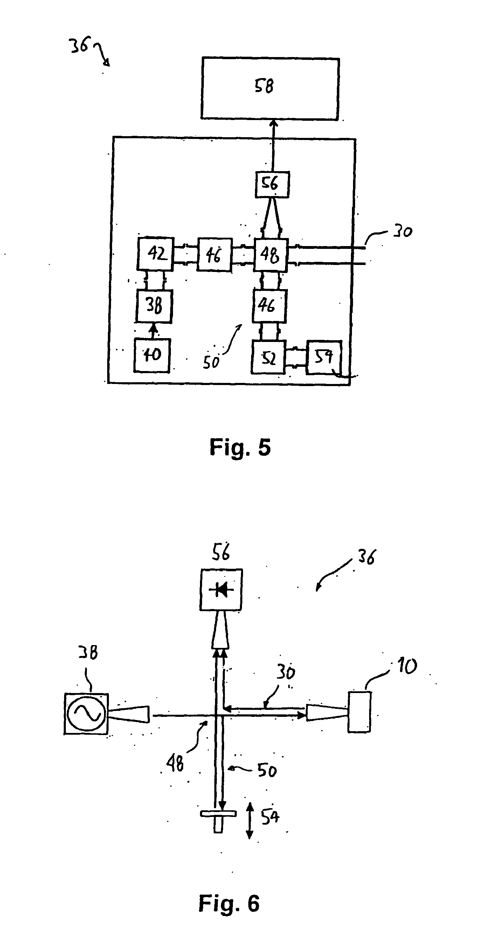

Ein Beispiel für eine geeignete Mikrowellenbrücke 36 ist in den Figuren 5 und 6 gezeigt. Figur 5 zeigt die wesentlichen Komponenten der Mikrowellenbrücke 36 in einem Blockschaltbild, und Figur 6 zeigt den funktionellen Aufbau der Mikrowellenbrücke 36.

Wie in Figur 5 zu sehen ist, umfasst die Mikrowellenbrücke 36 einen Mikrowellenoszillator 38, der mit einer Spannungsversorgung 40 verbunden ist. Ferner umfasst die Mikrowellenbrücke 36 einen mechanischen Mikrowellenschalter 42 und einen Attenuator 46. Ein Strahlteiler 48 ist vorgesehen, um das Mikrowellensignal zwischen einem Signal-Arm, nämlich dem Mikrowellen-Wellenleiter 30, der mit der Doppelresonanzstruktur 10 verbunden ist, und einem Referenz-Arm 50 aufzuspalten, der aus einem weiteren Attenuator 46, einem Wellen-Messgerät 52 und einem verstellbaren Reflektor 54 besteht. Ferner umfasst die Mikrowellenbrücke 36 einen Detektor 56, der mit einem Lock-In-Verstärker 58 verbunden ist. Die entsprechenden Komponenten sind in Figur 6 mit denselben Bezugszeichen bezeichnet.

Die Mikrowellenbrücke 36 von Figuren 5 und 6 kann in einem EPR-Detektionsmodus und einem DNP-Modus betrieben werden. Dazu ist die Mikrowellenbrücke 36, wie besonders in Figur 6 gut zu erkennen ist, als Michelson-Interferometer ausgebildet, wobei die EPR-Spektroskopie mit Hilfe eines Signals der vom Mikrowellen-Resonator 32 reflektierten Mikrowellen durchgeführt wird. Die höchste EPR-Empfindlichkeit kann erreicht werden, wenn der Strahlteiler 48 je eine Hälfte der einfallenden Leistung in den Referenz-Arm 50 und in den Signal-Arm, d.h. den Mikrowellen-Wellenleiter 30 leitet. Diese Aufspaltung der Leistung ist jedoch nicht optimal für den DNP-Modus, weil im DNP-Modus so viel Mikrowellenleistung wie möglich in die Doppelresonanzstruktur, also den Signal-Arm, eingespeist werden soll. Zu diesem Zweck kann der Strahlteiler 48 durch einen alternativen Strahlteiler ausgetauscht werden, der beispielsweise 99,5% der Leistung in den Signal-Arm (Wellenleiter 30) treten lässt und lediglich 0,5% der Leistung in den Referenz-Arm 50 ablenkt.

Im DNP-NMR-Modus ist der HF-Anschluss 20 der Doppelresonanzstruktur 10 mit einer herkömmlichen NMR-Einrichtung, einer sogenannten NMR-Konsole verbunden. Im ENDOR-Modus wird der HF-Anschluss 20 statt mit der NMR-Konsole mit einer geeigneten HF-Quelle verbunden.

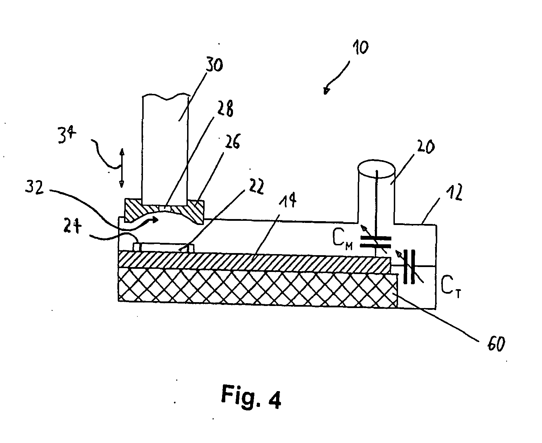

Figur 4 zeigt eine alternative Ausführungsform der Doppelresonanzstruktur 10, bei der der Streifen-Resonator 14 auf einem dielektrischen Substrat 60 angeordnet ist. Einen auf einem derartigen Substrat (60) angeordneten Streifen-Resonator (14) bezeichnet man auch als "Microstrip".

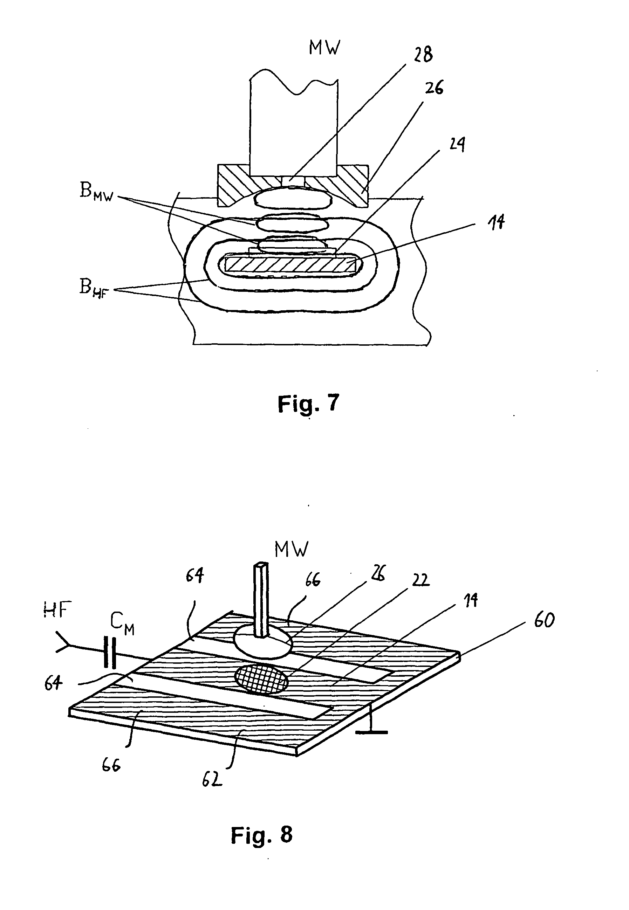

In Figur 7 ist eine Querschnittsansicht ähnlich derjenigen von Figur 2 und Figur 3 gezeigt, in der sowohl das Mikrowellenmagnetfeld $B_{MW}$ als auch das HF-Magnetfeld $B_{HF}$ eingezeichnet sind. In den Ausführungsformen von Figur 1 bis Figur 4 ist das HF-Feld $B_{HF}$ in dem Gehäuse 12 eingeschlossen. Das Gehäuse 12 hilft somit dabei, das Magnetfeld zu lokalisieren. Figur 8 zeigt eine alternative Ausführungsform, mit der das Magnetfeld $B_{HF}$ auf besonders vorteilhafte Weise in der Nähe der Probe 22 konzentriert werden kann, und bei der dazu darüber hinaus kein Gehäuse benötigt wird. Bei der Ausführungsform von Figur 8 ist ähnlich wie derjenigen von in Figur 4 eine dielektrische Schicht 60 vorgesehen, auf der eine Metallisierungsschicht 62, in Figur 8 durch Schraffur gekennzeichnet, angeordnet ist. Zwei längliche Aussparungen 64 in der Metallisierungsschicht sind beiderseits der Probe 22 vorgesehen, so dass sich die metallisierte Schicht 62 in drei streifenförmige Abschnitte unterteilt: einen mittleren Abschnitt 14, der den Streifen-Resonator bildet, sowie zwei äußere Abschnitte 66. Wenn an dem in der Darstellung von Figur 8 linken Ende des mittleren Abschnitts 14, d.h. des "Streifen-Resonators", ein hochfrequentes elektrisches Wechselfeld angelegt wird, wird ein entsprechendes Magnetfeld $B_{HF}$ (in Figur 8 nicht gezeigt) induziert, welches ähnlich wie in Figur 7 gezeigt den mittleren Abschnitt 14 umgibt und durch die freigelassenen Streifen 64 durchtaucht. Dadurch wird das HF-Feld $B_{HF}$ in der Nähe der Probe 22 konzentriert, so dass sich am Probenort ein starkes Magnetfeld bilden kann. Gleichzeitig hat dieser Aufbau den Vorteil, dass er das HF-Feld auch ohne ein Gehäuse konzentriert, was die Wärmedissipation begünstigt. Zudem unterstützen auch die außen liegenden Streifen 66 die Wärmedissipation, ohne die räumliche Konzentration des Magnetfeldes zu stören.

Wie in den obigen Ausführungsbeispielen gezeigt wurde, gestattet die Doppelresonanzstruktur 10 der vorliegenden Erfindung DNP-NMR- und ENDOR-Experimente mit sehr starken NMR- und EPR-Feldern und vergleichsweise großen Probenvolumina. Tatsächlich sind die Probenvolumina, die verwendet werden können, rund 10 Mal so groß wie beim eingangs beschriebenen Helix-Resonator aus dem Stand der Technik. Ein besonderer Vorteil der Doppelresonanzstruktur 10 besteht darin, dass sie sehr effektiv Wärme von der Probe abführen kann, so dass sich beispielsweise Biomoleküle in wässriger Lösung trotz hoher absorbierter Mikrowellenleistung untersuchen lassen, ohne dass die Temperatur der Probe in unzulässigem Umfang ansteigt. Dies macht die Doppelresonanzstruktur 10 insbesondere für die Untersuchung flüssiger bzw. wässriger Proben äußerst vorteilhaft.

Die gezeigte Doppelresonanzstruktur eignet sich insbesondere für die Strukturanalyse von Biomolekülen (2D-NMR), kinetische Studien, da die Messzeiten deutlich verringert sind, die Analyse komplexer (Bio-)Molekül-Mischungen, beispielsweise die Analyse von Metaboliten, die Identifizierung und Überwachung von Verunreinigungen und für ein Liganden- und Biomarker-Screening. Ferner können mit der Doppelresonanzstruktur 10 auf vorteilhafte Weisung dynamische Molekülwechselwirkungen untersucht werden. Darüberhinaus ist die Doppelresonanzstruktur bei 2D- und 3D-Analysen von kondensierter Materie, beispielsweise geordneten Kristallen, Lipidschichten und Membranen geeignet und für die NMR-Mikroskopie verwendbar.

In einem ENDOR-Spektroskopie-Modus kann die Doppelresonanzstruktur 10 auf vorteilhafte Weise bei der Untersuchung von Defekten in Halbleitern, Chiralitäten und endohedralen Komplexen (Fullerenen) verwendet werden.

Bezugszeichenliste:

| | |
|---|---|
| 10 | Doppelresonanzstruktur |
| 12 | Gehäuse |
| 14 | Streifen-Resonator |
| 16 | erstes Ende des Streifen-Resonators 14 |
| 18 | zweites Ende des Streifen-Resonators 14 |
| 20 | HF-Anschluss |
| 22 | Probe |
| 24 | Probenring |
| 26 | sphärischer Spiegel |
| 28 | Iris |
| 30 | Wellenleiter |
| 32 | MW-Resonator |
| 34 | Doppelpfeil |
| 36 | Mikrowellenbrücke |
| 38 | MW-Oszillator |
| 40 | Spannungsquelle |
| 42 | mechanischer Mikrowellenschalter |
| 46 | Attenuator |
| 48 | Strahlteiler |
| 50 | Referenz-Arm |
| 52 | Wellenmesseinrichtung |
| 54 | Reflektor |
| 56 | Detektor |
| 58 | Lock-In-Verstärker |
| 60 | dielektrisches Substrat |
| 62 | Metallisierungsschicht |
| 64 | frei gelassener Streifen in der Metallisierungsschicht 62 |
| 66 | äußerer Metallisierungsstreifen |

**Patentansprüche**

1. Doppelresonanzstruktur (10) für DNP-NMR und/ oder ENDOR-Experimente,
   mit einem Mikrowellen-Resonator (32) zur Erzeugung elektromagnetischer Felder, die für EPR geeignet sind,
   und mit einem HF-Resonator (14) zur Erzeugung elektromagnetischer Felder, die für NMR geeignet sind, **dadurch gekennzeichnet,**
**dass** der HF-Resonator (14) durch einen Streifen-Resonator (14) gebildet wird, wobei ein Abschnitt des Streifen-Resonators (14) gleichzeitig einen Teil des Mikrowellen-Resonators (32) bildet, der als Spiegel für Mikrowellen dienen kann.

2. Doppelresonanzstruktur (10) nach Anspruch 1, bei der der Mikrowellen-Resonator (32) einen sphärischen Spiegel (26) und einen ebenen Spiegel für Mikrowellen umfasst, die einander gegenüberstehen, wobei der ebene Spiegel durch einen Abschnitt des Streifen-Resonators (14) gebildet wird.

3. Doppelresonanzstruktur (10) nach Anspruch 1 oder 2, bei der in dem sphärischen Spiegel eine Iris (28) ausgebildet ist, durch die Mikrowellen in den Mikrowellen-Resonator (32) einspeisbar sind, wobei die Iris (28) vorzugsweise schlitzförmig ist, um linear polarisierte Mikrowellenmoden in dem Mikrowellen-Resonator (32) zu erzeugen, oder die Iris (28) vorzugsweise kreisförmig ist, um zirkular polarisierte Mikrowellenmoden in dem Mikrowellen-Resonator (32) zu erzeugen.

4. Doppelresonanzstruktur (10) nach einem der vorhergehenden Ansprüche, bei der der sphärische Spiegel (26) und der ebene Spiegel so ausgebildet und angeordnet sind, dass sich eine $TEM_{00n}$-Mikrowellenmode zwischen ihnen ausbilden lässt, und/oder bei der der Mikrowellen-Resonator (32) mit einer Mikrowellenquelle (36) verbunden ist und in der niedrigsten Strahlungsmode des Mikrowellen-Resonators (32) betreibbar ist.

5. Doppelresonanzstruktur (10) nach einem der vorhergehenden Ansprüche, bei der der Streifen-Resonator (14) ein erstes Ende (16) hat, welches auf Massepotential liegt, und der Abschnitt des Streifen-Resonators (14), der einen Teil des Mikrowellen-Resonators (32) bildet, im Bereich des ersten Endes (16) des Streifen-Resonators angeordnet ist, wobei der Streifen-Resonator (14) vorzugsweise ein zweites Ende (18) hat, an dem ein Kondensator $C_T$ zum Einstellen der Resonanzfrequenz des Streifen-Resonators (14) vorgesehen ist.

6. Doppelresonanzstruktur (10) nach einem der vorhergehenden Ansprüche, bei der eine Stelle (24) zur Aufnahme einer Probe (22) vorgesehen ist, die mit dem Streifen-Resonator (14) wärmeleitend verbunden ist, wobei vorzugsweise die Stelle (24) zur Aufnahme einer Probe (22) so ausgebildet ist, dass die aufgenommene Probe (22) mit dem Streifen-Resonator (14) in direktem Kontakt ist, wobei die Stelle (24) zur Aufnahme einer Probe (22) vorzugsweise eine Einrichtung (24) zur Aufnahme einer flüssigen Probe umfasst, wobei der Pegel der aufzunehmenden flüssigen Probe (22) vorzugsweise bis zu einem Zehntel der Resonanzwellenlänge des Mikrowellen-Resonators (32) beträgt.

7. Doppelresonanzstruktur (10) nach einem der vorhergehenden Ansprüche, bei der ein Anschluss (20) für eine HF-Leitung vorgesehen ist, über die HF Signale an den Streifen-Resonator (14) anlegbar sind, wobei vorzugsweise ein einstellbarer Matching-Kondensator $C_M$ zwischen dem Streifen-Resonator (14) und dem Anschluss (20) für HF-Signale vorgesehen ist, und/oder die Doppelresonanzstruktur (10) als Probenkopf ausgebildet ist, der in eine Bohrung eines Magneten einführbar ist, wobei der Probenkopf vorzugsweise ein Gehäuse (12) hat, welches mit Massepotenzial verbunden ist.

8. Doppelresonanzstruktur (10) nach einem der vorhergehenden Ansprüche, bei der der Streifen-Resonator (14) durch einen Abschnitt einer Leiterfläche (62) gebildet ist, der entlang eines Teils seiner Länger durch nichtleitende Aussparungen (64) von dem Rest der Leiterfläche getrennt ist, wobei die Leiterfläche insbesondere durch eine Metallisierungsschicht (62) auf einem dielektrischen Substrat gebildet ist und die nichtleitenden Aussparungen durch Bereiche (64) gebildet sind, an denen die Metallisierung ausgespart ist.

9. DNP-NMR-Spektrometer, das Folgendes umfasst:

   eine Doppelresonanzstruktur (10) nach einem der Ansprüche 1-8,
   eine Mikrowellenquelle (36), die zur Einspeisung von Mikrowellen in den Mikrowellen-Resonator (32) mit der Doppelresonanzstruktur (10) verbunden ist, und
   eine NMR-Vorrichtung, die mit der Doppelresonanzstruktur (10) zur Einspeisung von HF-Signalen in den Streifen-Resonator (14) und zum Empfangen von HF-Signalen von dem Streifen-Resonator (14) verbunden ist.

10. ENDOR-Spektrometer, das Folgendes umfasst:

   eine Doppelresonanzstruktur (10) nach einem der Ansprüche 1-8,
   eine Mikrowellen-Einrichtung (36), die zur Einspeisung von Mikrowellen in den Mikrowellen-Resonator (32) und zum Empfang von Mikrowellen von dem Mikrowellen-Resonator (32) mit der Doppelresonanzstruktur (10) verbunden ist, und
   eine HF-Quelle, die mit der Doppelresonanzstruktur (10) zur Einspeisung von HF-Signalen in den Streifen-Resonator (14) verbunden ist.

**11.** Kombiniertes DNP-NMR/ENDOR-Spektrometer, das Folgendes umfasst:

> eine Doppelresonanzstruktur (10) nach einem der Ansprüche 1-8,
> eine Mikrowellen-Einrichtung (36), die geeignet ist, in einem NMR-Modus Mikrowellen-Signale in den Mikrowellen-Resonator (32) der Doppelresonanzstruktur (10) einzuspeisen, und in einem ENDOR-Modus Mikrowellen in den Mikrowellen-Resonator (32) der Doppelresonanzstruktur (10) einzuspeisen und Mikrowellen-Signale von dem Mikrowellen-Resonator (32) zu empfangen und zu detektieren,
> und eine Hochfrequenz-Einrichtung, die geeignet ist, in einem NMR-Modus HF-Signale in den Streifen-Resonator (14) der Doppelresonanzstruktur (10) einzuspeisen, HF-Signale von dem Streifen-Resonator (14) zu empfangen und zu detektieren, und in einem ENDOR-Modus HF-Signale in den Streifen-Resonator (14) einzuspeisen.

**12.** Verfahren zur Untersuchung von Proben mittels DNP-NMR und/oder ENDOR, bei dem eine Probe (22) in einer Doppelresonanzstruktur (10) angeordnet wird, die einen Mikrowellen-Resonator (32) und einen HF-Resonator (14) umfasst, mit Hilfe des Mikrowellen-Resonators (32) ein Mikrowellenfeld erzeugt wird, welches geeignet ist, EPR-Übergänge in der Probe (22) zu induzieren, und mit Hilfe des HF-Resonators ein HF-Feld erzeugt wird, welches geeignet ist, NMR-Übergänge in der Probe (22) zu induzieren, **dadurch gekennzeichnet, dass** der HF-Resonator durch einen Streifen-Resonator (14) gebildet wird, wobei ein Abschnitt des Streifen-Resonators (14) gleichzeitig einen Teil des Mikrowellen-Resonators (32) bildet, der als Spiegel für Mikrowellen dient.

**13.** Verfahren nach Anspruch 12, bei dem der Mikrowellen-Resonator (32) einen sphärischen Spiegel (26) und einen ebenen Spiegel für Mikrowellen umfasst, die einander gegenüberstehen, wobei der ebene Spiegel durch einen Abschnitt des Streifen-Resonators (14) gebildet wird, wobei in dem sphärischen Spiegel (26) vorzugsweise eine Iris (28) ausgebildet ist, durch die Mikrowellen in den Mikrowellen-Resonator (32) eingespeist werden, und/oder bei dem in dem Mikrowellen-Resonator (32) eine $TEM_{00n}$-Mode erzeugt wird.

**14.** Verfahren nach einem der Ansprüche 12 oder 13, bei dem die Probe (22) flüssig ist, und/oder bei dem die Probe (22) mit dem Streifen-Resonator (14) wärmeleitend in Kontakt ist, insbesondere direkt auf dem Streifen-Resonator (14) aufgebracht ist.

**Claims**

**1.** A double-resonance structure (10) for DNP-NMR and/or ENDOR experiments, having a microwave resonator (32) for generating electromagnetic fields suitable for EPR, and having an HF resonator (14) for generating electromagnetic fields suitable for NMR, **characterized in that** the HF resonator (14) is formed by a strip resonator (14), such that a section of the strip resonator (14) at the same time forms a part of the microwave resonator (32) which can act as a reflector for microwaves.

**2.** The double-resonance structure (10) according to Claim 1, wherein the microwave resonator (32) includes a spherical reflector (26) and a planar reflector for microwaves which are opposite from one another, the planar reflector being formed by a section of the strip resonator (14).

**3.** The double-resonance structure (10) according to Claim 1 or 2, wherein an iris (28) is formed in the spherical reflector through which the microwaves can be supplied into the microwave resonator (32) wherein the iris (28) is preferably slot-shaped to generate linearly polarized microwave modes in the microwave resonator (32), or wherein the iris (28) is preferably circular to generate circularly polarized microwave modes in the microwave resonator (32).

**4.** The double-resonance structure (10) according to any one of the preceding claims, wherein the spherical reflector (26) and the planar reflector are designed and arranged, so that a $TEM_{00n}$ microwave mode can be formed between them, and/or wherein the microwave resonator (32) is connected to a microwave source (36) and can be operated in the lowest radiation mode of the microwave resonator (32).

**5.** The double-resonance structure (10) according to any one of the preceding claims, wherein the strip resonator (14) has a first end (16), which is at ground potential, and a section of the strip resonator (14) forming part of the microwave resonator (32) is arranged in the area of the first end (16) of the strip resonator, wherein the strip resonator (14) preferably has a second end (18) on which a capacitor $C_T$ is provided for adjusting the resonant frequency of the strip resonator (14).

**6.** The double-resonance structure (10) according to any one of the preceding claims, wherein a place (24) having a thermally conducting connection to the strip resonator (14) is provided for holding a sample (22),

wherein the place (24) for holding a sample (22) is preferably designed so that the sample (22) being held is in direct contact with the strip resonator (14), wherein the place (24) for holding the sample (22) preferably includes a device (24) for holding a liquid sample,

wherein the level of the liquid sample (22) to be held preferably amounts one-tenth or less of the resonant wavelength of the microwave resonator (32).

7.  The double-resonance structure (10) according to any one of the preceding claims, wherein a connection (20) for an HF line, by means of which the HF signals can be applied to the strip resonator (14), is provided,

    wherein an adjustable matching capacitor $C_M$ is preferably provided between the strip resonator (14) and the connection (20) for HF signals, and/or the double-resonance structure (10) is designed as a sample head insertable into a borehole in a magnet, wherein the sample head preferably has a housing (12), which is connected to ground potential.

8.  The double-resonance structure (10) according to any one of the preceding claims, wherein the strip resonator (14) is formed by a section of a conductor surface (62), which is separated from the remainder of the conductor surface along a portion of its length by nonconductive omissions (64),

    wherein in particular, the conductor surface is formed by a metallization layer (62) on a dielectric substrate, and the nonconductive omissions are formed by areas (64) where the metallization is omitted.

9.  A DNP-NMR spectrometer, comprising the following: a double-resonance structure (10) according to any one of Claims 1-8, a microwave source (36) connected to the double-resonance structure (10) for input of microwaves into the microwave resonator (32), and an NMR device connected to the double-resonance structure (10) for input of HF signals into the strip resonator (14) and for receiving HF signals from the strip resonator (14).

10. An ENDOR spectrometer comprising the following: a double-resonance structure (10) according to any one of Claims 1-8, a microwave device (36) connected to the double-resonance structure (10) for input of microwaves into the microwave resonator (32) and for receiving microwaves from the microwave resonator (32), and an HF source connected to the double-resonance structure (10) for input of HF signals into the strip resonator (14).

11. A combined DNP-NMR/ENDOR spectrometer comprising the following: a double-resonance structure (10) according to any one of Claims 1-8, a microwave device (36) suitable for input of microwave signals into the microwave resonator (32) of the double-resonance structure (10) in an NMR mode, and for input of microwaves into the microwave resonator (32) of the double-resonance structure (10) and for receiving and detecting microwave signals from the microwave resonator (32) in an ENDOR mode, and a highfrequency device suitable for input of HF signals into the strip resonator (14) of the double-resonance structure (10), receiving and detecting HF signals from the strip resonator (14) in an NMR mode, and for input of HF signals into the strip resonator (14) in an ENDOR mode.

12. A method for investigating samples by means of DNP-NMR and/or ENDOR, in which a sample (22) is arranged in a double-resonance structure (10), said double-resonance structure comprising a microwave resonator (32) and an HF resonator (14), a microwave field is generated with the help of the microwave resonator (32), said microwave field being suitable for inducing EPR transitions in the sample (22), and an HF field is generated with the help of the HF resonator, said HF field being suitable for inducing NMR transitions in the sample (22), **characterized in that** the HF resonator is formed by a strip resonator (14), such that a section of the strip resonator (14) at the same time forms a part of the microwave resonator (32), which can act as a microwave reflector.

13. The method according to Claim 12, wherein the microwave resonator (32) comprises a spherical reflector (26) and a planar reflector for microwaves, which are opposite one another, such that the planar reflector is formed by a section of the strip resonator (14),

    wherein preferably an iris (28), through which microwaves are fed into the microwave resonator (32), is formed in the spherical reflector (26), and/or wherein a $TEM_{00n}$ mode is generated in the microwave resonator (32).

14. The method according to any one of Claims 12 or 13, wherein the sample (22) is liquid, and/or wherein the sample (22) is in thermally conducting contact with the strip resonator (14), in particular being applied directly to the strip resonator (14).

**Revendications**

1.  Structure de double résonance (10) pour des essais RMN-DPN et/ou ENDOR,

    comprenant un résonateur micro-ondes (32) pour la génération de champs électromagnétiques qui sont appropriés à la RPE,

    et comprenant un résonateur HF (14) pour la génération de champs électromagnétiques qui sont appropriés à la RMN, **caractérisée en ce que** le résonateur HF (14) est formé par un résonateur à bandes (14), une section du résonateur à bandes (14) formant simultanément une partie du résonateur micro-ondes (32) qui peut servir de miroir pour des micro-ondes.

2. Structure de double résonance (10) selon la revendication 1 dans laquelle le résonateur micro-ondes (32) comprend un miroir sphérique (26) et un miroir plan pour des micro-ondes, miroirs qui se font face, le miroir plan étant formé par une section du résonateur à bandes (14).

3. Structure de double résonance (10) selon les revendications 1 ou 2 dans laquelle un iris (28) est formé dans le miroir sphérique, iris par lequel les micro-ondes peuvent être emmagasinées dans le résonateur micro-ondes (32), l'iris (28) étant de préférence en forme de fente afin de générer des modes de micro-ondes polarisées linéairement dans le résonateur micro-ondes (32), ou l'iris (28) étant de préférence de forme circulaire afin de générer des modes de micro-ondes polarisées circulairement dans le résonateur micro-ondes (32).

4. Structure de double résonance (10) selon l'une des revendications précédentes dans laquelle le miroir sphérique (26) et le miroir plan sont ainsi conçus et agencés que le mode de micro-ondes $TEM_{00n}$ est formé entre eux, et/ou le résonateur micro-ondes (32) est relié à une source micro-ondes (36) et peut être mis en oeuvre dans le mode de rayonnement du résonateur micro-ondes (32) le plus bas.

5. Structure de double résonance (10) selon l'une des revendications précédentes dans laquelle le résonateur à bandes (14) a une première extrémité (16) qui est au potentiel de masse et la section du résonateur à bandes (14) qui forme une partie du résonateur micro-ondes (32) est agencée dans la zone de la première extrémité (16) du résonateur à bandes, le résonateur à bandes (14) possédant de préférence une seconde extrémité (18) où est prévu un condensateur CT pour le réglage de la fréquence de résonance du résonateur à bandes (14).

6. Structure de double résonance (10) selon l'une des revendications précédentes dans laquelle un lieu (24) pour la réception d'un échantillon (22) est prévu, échantillon qui est relié de manière conductrice de la chaleur avec le résonateur à bandes (14), le lieu (24) pour la réception d'un échantillon (22) étant de préférence conçu de telle façon que l'échantillon (22) réceptionné est en contact direct avec le résonateur à bandes (14), le lieu (24) pour la réception d'un échantillon (22) étant de préférence formé d'un dispositif (24) pour la réception d'un échantillon liquide, l'échelle de grandeur de l'échantillon (22) liquide à réceptionner atteignant de préférence jusqu'à un dixième de la longueur d'onde de résonance du résonateur micro-ondes (32).

7. Structure de double résonance (10) selon l'une des revendications précédentes dans laquelle un branchement (20) pour une ligne HF est prévu, par lequel les signaux HF peuvent être appliqués au résonateur à bandes (14), un condensateur CM Matching pouvant être réglé étant de préférence prévu entre le résonateur à bandes (14) et le branchement (20) pour les signaux HF, et/ou la structure de double résonance (10) est sous la forme d'une tête de mesure qui peut être introduite dans le taraudage d'un aimant, la tête de mesure possédant de préférence un boîtier qui est relié avec le potentiel de masse.

8. Structure de double résonance (10) selon l'une des revendications précédentes dans laquelle le résonateur à bandes (14) est formé par une section d'une surface conductrice (62) qui est séparée du reste de la surface conductrice sur une partie de ses longueurs par des parties réservées (64) non conductrices, la surface conductrice étant en particulier formée par une couche de métallisation (62) sur un substrat diélectrique et les parties réservées non conductrices étant formées par des domaines (64) sur lesquels la métallisation est omise.

9. Spectromètre RMN-DNP qui comprend ce qui suit :

une structure de double résonance (10) selon l'une des revendications 1-8,
une source de micro-ondes (36) qui est reliée avec la structure de double résonance (10) pour l'emmagasinage de micro-ondes dans le résonateur micro-ondes (32), et
un dispositif RMN qui est relié avec la structure. de double résonance (10) pour l'emmagasinage de signaux HF dans le résonateur à bandes (14) et pour la réception de signaux HF du résonateur à bandes (14).

10. Spectromètre ENDOR qui comprend ce qui suit :

une structure de double résonance (10) selon l'une des revendications 1-8,
un dispositif micro-ondes (36) qui est relié avec la structure de double résonance (10) pour l'emmagasinage de micro-ondes dans le résonateur micro-ondes (32) et pour la réception de micro-ondes du résonateur micro-ondes (32), et
une source HF qui est reliée avec la structure de double résonance (10) pour l'emmagasinage de signaux HF dans le résonateur à bandes (14).

11. Spectromètre combiné RMN-DNP/ENDOR qui comprend ce qui suit :

une structure de double résonance (10) selon l'une des revendications 1-8, un dispositif micro-ondes (36) qui est approprié pour emmagasiner des signaux de micro-ondes dans un mode RMN dans le résonateur micro-ondes (32) de la structure de double résonance (10), et pour emmagasiner des micro-ondes en mode ENDOR dans le résonateur micro-ondes (32) de la structure de double résonance (10) et pour capter et détecter des signaux micro-ondes du résonateur micro-ondes (32) et un dispositif de haute fréquence qui est approprié pour emmagasiner des signaux HF en mode RMN dans le résonateur à bandes (14) de la structure de double résonance (10), pour capter et détecter des signaux HF du résonateur à bandes (14), et pour emmagasiner des signaux HF en mode ENDOR dans le résonateur à bandes (14).

12. Procédé pour l'examen d'échantillon au moyen de la RMN-DNP et/ou de l'ENDOR pour lequel un échantillon (22) est agencé dans une structure de double résonance (10) qui comprend un résonateur micro-ondes (32) et un résonateur HF (14),

un champ de micro-ondes est généré à l'aide du résonateur micro-ondes (32), qui est approprié à induire des transitions RPE dans l'échantillon (22) et un champ HF est généré à l'aide du résonateur HF qui est approprié pour induire des transitions RMN dans l'échantillon, **caractérisé en ce que** le résonateur HF est formé par un résonateur à bandes (14), une section du résonateur à bandes (14) formant simultanément une partie du résonateur micro-ondes (32) qui sert de miroir pour les micro-ondes.

13. Procédé selon la revendication 12 dans lequel le résonateur micro-ondes (32) comprend un miroir sphérique (26) et un miroir plan pour les micro-ondes, miroirs qui se font face, le miroir plan étant formé par une section du résonateur à bandes (14), un iris (28) étant de préférence formé dans le miroir sphérique (26) iris par lequel les micro-ondes sont emmagasinées dans le résonateur micro-ondes (32) et/ou un mode $TEM_{00n}$ est généré dans le résonateur micro-ondes (32).

14. Procédé selon l'une des revendications 12 ou 13 dans lequel l'échantillon (22) est liquide et/ou dans lequel l'échantillon (22) est en contact par conduction thermique avec le résonateur à bandes (14), en particulier est rapporté directement sur le résonateur à bandes (14).

Fig. 2

Fig. 3

Fig. 1

Fig. 4

36

**Fig. 5**

**Fig. 6**

MW

28

26

24

$B_{MW}$

14

$B_{HF}$

**Fig. 7**

MW

64

66

26

22

14

HF

$C_M$

60

64

**Fig. 8**

**IN DER BESCHREIBUNG AUFGEFÜHRTE DOKUMENTE**

**In der Beschreibung aufgeführte Patentdokumente**

- JP 2005121409 A

**In der Beschreibung aufgeführte Nicht-Patentliteratur**

- **Weis et al.** High field DNP and ENDOR with novel multiple-frequency resonance structure. *J. Magn. Reson.,* 1999, vol. 140, 293-299